(19) Europäisches Patentamt

European Patent Office

Office européen des brevets

(11) **EP 1 430 297 B1**

(12) **EUROPÄISCHE PATENTSCHRIFT**

(45) Veröffentlichungstag und Bekanntmachung des Hinweises auf die Patenterteilung:
**14.06.2006 Patentblatt 2006/24**

(51) Int Cl.:
***G01N 27/90*** (2006.01)          ***G01R 31/02*** (2006.01)
***G01R 31/34*** (2006.01)

(21) Anmeldenummer: **02801973.5**

(22) Anmeldetag: **23.09.2002**

(86) Internationale Anmeldenummer:
**PCT/IB2002/003914**

(87) Internationale Veröffentlichungsnummer:
**WO 2003/036287 (01.05.2003 Gazette 2003/18)**

(54) **VERFAHREN UND EINRICHTUNG ZUR KONTROLLE VON LAMELLIERTEN EISENBLECHPAKETEN VON ELEKTRISCHEN MASCHINEN AUF BLECHSCHLÜSSE**

METHOD AND DEVICE FOR CONTROLLING LAMINATED STEEL SHEET STACKS OF ELECTRICAL MACHINES IN A VIEW TO DETECT STEEL SHEET SHORT-CIRCUITS

PROCEDE ET DISPOSITIF DE CONTROLE D'EMPILEMENTS DE TOLES DE FER FEUILLETEES DE MACHINES ELECTRIQUES A LA RECHERCHE DE COURTS-CIRCUITS ENTRE TOLES

(84) Benannte Vertragsstaaten:
**CH DE ES FR GB LI PT**

(30) Priorität: **24.09.2001 US 324061 P**
**05.04.2002 CH 5862002**

(43) Veröffentlichungstag der Anmeldung:
**23.06.2004 Patentblatt 2004/26**

(73) Patentinhaber: **Alstom Technology Ltd**
**5400 Baden (CH)**

(72) Erfinder:
• **KIRCHHOFF, Ingo**
**CH-5454 Bellikon (CH)**

• **NODWELL, Eric**
**Vancouver, British Columbia V6T IN8 (CA)**
• **POSEDEL, Zlatimir**
**CH-5432 Neuenhof (CH)**
• **HOBELSBERGER, Max**
**5303 Würenlingen (CH)**

(56) Entgegenhaltungen:
CH-A- 676 526          DE-A- 3 542 159
GB-A- 1 521 203          GB-A- 2 044 936
US-A- 4 628 261          US-A- 5 895 439

**Beschreibung**

**TECHNISCHES GEBIET**

Die Erfindung bezieht sich auf ein Verfahren zur Kontrolle lamellierter Eisenblechpakete von elektrischen Maschinen auf Blechschlüsse, bei welchem das Eisenblechpaket mittels einer Hilfswicklung magnetisiert wird und die Eisenoberfläche mittels einer Messspulenanordnung mit nachgeschaltetem Messgerät abgetastet wird.

Die Erfindung bezieht sich ausserdem auf eine Vorrichtung zur Durchführung des Verfahrens.

**STAND DER TECHNIK**

Lamellierte Eisenblechpakete, insbesondere von elektrischen Maschinen, werden bei der Herstellung und im Betrieb im Zuge von Wartungsarbeiten häufig mit dem Messverfahren der Statorblechringerregung mit Nenninduktion auf Blechschlüsse kontrolliert. Dieses Verfahren, welches die Wirkung von Blechschlussströmen in örtlichen Temperaturunterschieden anzeigt, verlangt eine leistungsstarke und regulierbare Spannungsquelle und Erregerwindungen mit grossen Querschnitten (sog. Hot Spot Methode mit Hilfe von z.B. Infrarotkameras). Bei Statoren mit eingebauten Wicklungsstäben sind mit dieser Kontrolle nur die Fehlerstellen (Kurzschluss mehrerer Bleche untereinander) an der Zahnoberfläche und nicht die Blechfehler im Nutgrund und an den Nutseiten erkennbar. Mit dieser Methode werden nur Blechschlüsse mit einem bestimmten Kontaktwiderstand und resultierenden örtlichen Temperaturunterschieden erkannt und damit nicht alle Blechschlussstellen. Die Temperaturerhöhung allein reicht nicht für eine quantitative Beurteilung der Blechschlussstelle. Eine quantitative Beurteilung dieser Fehlerstellen ist aber erstrebenswert, da die Leistung in einer Fehlerstelle letzten Endes das entscheidende Kriterium dafür ist, ob ein derartiger Bereich in der Lage ist, ein so genanntes "core melting", d.h. ein beim Betrieb auftretendes Verschmelzen infolge der hohen Erwärmung an der Fehlerstelle, auszulösen.

Die US 5,321,362 beschreibt ein so genanntes Niederinduktionsverfahren zur Ermittlung der Kurzschlussströme an Blechkontakten, bei welchem zunächst das Blechpaket über eine um das Statorblechpaket gelegte Spule schwach magnetisiert wird, und anschliessend mit einer Messspulenanordnung das Streufeld auf dem Blechpaket vermessen wird. Die Methode weist den Vorteil auf, dass nicht so hohe Induktionsströme notwendig sind, und ausserdem Fehlerstellen nicht nur an der Zahnoberfläche lokalisiert werden können. Es können dabei auch Fehlerstellen erkannt werden, welche sich beim obengenannten Verfahren momentan nicht erhitzen, und die Messung ist bei eingebautem Rotor möglich. Die US 5,321,362 geht dabei von einer ausschliesslichen Messung des Stromes aus, und lässt deshalb keinen verlässlichen Rückschluss auf die in der Fehlerstelle auftretende Leistung zu.

Andererseits beschreibt die CH 676526 A5 ein Verfahren, bei welchem eine Lokalisierung der Fehlerstellen, sowohl auf der Zahnoberfläche als auch im Nutgrund und an den Nutseiten ermöglicht wird, und dies in quantitativer Weise. Es handelt sich dabei wiederum um ein Niederinduktionsverfahren, bei dem aber nicht einfach der Strom gemessen, sondern zusätzlich eine Referenzmessung vorgeschlagen wird, welche es erlaubt, durch entsprechende Rückrechnung direkt und quantitativ die in einer Fehlerstelle auftretende Leistung zu ermitteln.

Grundsätzlich problematisch ist im Zusammenhang mit derartigen Niederinduktionsverfahren die Tatsache, dass sie häufig eine eindeutige Lokalisierung von Fehlerstellen nicht erlauben, da auch Unterschiede im Verhalten des magnetischen Eisenkerns (z.B. infolge von Kühlschlitzen) zu Signalen führen können, welche bei diesen Verfahren ggf. auch als Fehlerstellen interpretiert werden.

**DARSTELLUNG DER ERFINDUNG**

Es ist daher Aufgabe der vorliegenden Erfindung, ein Verfahren zur Kontrolle lamellierter Eisenblechpakete von elektrischen Maschinen auf Blechschlüsse vorzustellen, bei welchem Verfahren das Eisenblechpaket mittels einer Hilfswicklung magnetisiert wird und die Eisenoberfläche mittels wenigstens einer Messspulenanordnung mit nachgeschaltetem Messgerät abgetastet wird, und welches eine möglichst eindeutige Lokalisierung der Fehlerstellen, d.h. möglicherweise vorhandener Blechschlüsse erlaubt.

Die Aufgabe wird durch ein Verfahren gemäss Anspruch 1 gelöst, wobei sowohl die Phase als auch die Amplitude des in der wenigstens einen Messspulenanordnung induzierten elektrischen Signals kombiniert zur Lokalisierung von Blechschlüssen verwendet wird.

Gemäss der vorliegenden Erfindung wird ein Blechschluss dadurch erkannt, dass ein im Vergleich zu den intakten Bereichen hoher Realteil des induzierten elektrischen Signals auftritt. Es zeigt sich nämlich, dass eben ein solcher hoher Realteil gerade Fehlerstellen, d.h. Bereiche, bei welchen einzelne Bleche untereinander über einen Kurzschluss verbunden sind, eindeutig charakterisiert. Dabei kann insbesondere bevorzugt dieser hohe Realteil mit Hilfe einer Polardarstellung ermittelt werden.

Die Richtung, welche in diesem Zusammenhang als "Realteil" bezeichnet wird, ist gewissermassen eine "ausgeprägte Richtung", und ist durch eine Eichmessung definiert, bei welcher eine Referenz mit Hilfe einer Eichstrom-Spule (Schleife) mit entsprechender Breite und entsprechendem Blechstrom gespeist wird.

Gemäss einer bevorzugten Ausführungsform der Erfindung kann das Verfahren mit einer Gradientenmessung kombiniert werden, das heisst mit einer Messung, welche auch eine eindeutige und quantifizierbare Lokalisierung der Fehlerstelle in radialer Richtung bezüglich des Stators erlaubt. Dies indem wenigstens eine weitere, von einer ersten Messspulenanordnung elektrisch getrennte Messspulenanordnung radial distanziert, aber mechanisch mit der ersten Messspulenanordnung verbunden, verwendet wird, und sowohl die Phase als auch die Amplitude der wenigstens zwei in den wenigstens zwei Messspulenanordnungen induzierten elektrischen Signale zur Lokalisierung von Blechschlüssen, insbesondere zu deren Lokalisierung in radialer Richtung, verwendet wird.

Die Eichmessung ist dadurch gekennzeichnet, dass die induzierten elektrischen Signale mit Signalen, die den Blechschlussströmen entsprechen, verglichen werden, wobei dazu als Referenz eine Schleife mit entsprechender Breite an der Oberfläche des Eisenblechpakets befestigt und mit entsprechendem Blechschlussstrom gespeist wird. Diese Methode erlaubt eine Quantifizierung der Fehlerstellen, d.h. sie erlaubt insbesondere die Bestimmung der Leistung, welche in einer Fehlerstelle effektiv auftritt. Damit ist es möglich, die tatsächlichen Fehlerstellen in Bezug auf ein mögliches "core melting" festzustellen.

Die Hilfswicklung zur Magnetisierung der Eisenblechpakete kann gemäss einer weiteren bevorzugten Ausführungsform dadurch realisiert werden, dass die Aufmagnetisierung des Eisenblechpakets insbesondere über die Rotorwelle, aus einer stromstarken Speisequelle, die zwischen beiden Maschinenseiten, insbesondere an der isolierten Welle, angeschlossen ist, erfolgt. Dabei wird bevorzugtermassen eine Magnetisierung des Eisenblechpakets im Bereich von 0,03 bis 0,7 Tesla, insbesondere von 0,1 Tesla mit einer Spannung von 220/110 Volt bei 50/60 Hz erzeugt.

Bei einer weiteren bevorzugten Ausführungsform der vorliegenden Erfindung wird die wenigstens eine Messspulenanordnung, oder werden bei Gradientenmessung die wenigstens zwei Messspulenanordnungen, in axialer Richtung auf dem Eisenblechpaket verschoben. Dabei werden die induzierten Signale, insbesondere in Form eines Fingerprint, als Funktion der Position der Messspulenanordnung ermittelt, wobei insbesondere Bereiche mit kritischen Blechschlüssen über den Realteil ermittelt und von Bereichen mit unkritischen Blechschlüssen unterschieden werden. Die kritischen Bereiche werden zur sofortigen Behebung markiert und die (momentan noch) unkritischen Bereiche für spätere Analysen dokumentiert.

Des Weiteren betrifft die vorliegende Erfindung eine Vorrichtung zur Durchführung eines Verfahrens gemäss Anspruch 12.

Weitere bevorzugte Ausführungsformen des erfindungsgemässen Verfahrens und der erfindungsgemässen Vorrichtung sind in den abhängigen Patentansprüchen beschrieben.

## KURZE BESCHREIBUNG DER FIGUREN

Die Erfindung soll nachfolgend anhand von Ausführungsbeispielen im Zusammenhang mit den Figuren erläutert werden. Es zeigen:

Fig. 1    eine perspektivische Ansicht auf einen Stator mit lamellierten Eisenblechpaketen, bei welchem die Wicklungen aus den Statornuten zwecks besserer Darstellung nicht abgebildet sind und bei welchem ein Fehlerstrom angedeutet ist;

Fig. 2    a) die mit der Messspulenanordnung gemessene Amplitude als Funktion der Position entlang der Statorachse; b) die mit der Messspulenanordnung gemessene Phase als Funktion der Position entlang der Statorachse;

Fig. 3    eine perspektivische Ansicht auf einen Stator mit lamellierten Eisenblechpaketen gemäss Fig. 1 mit einer Eichstrom-Spule;

Fig. 4    Polardarstellung (Realteil entlang y-Achse, Imaginärteil entlang x-Achse) der Messdaten gemäss Fig. 2 für den Bereich zwischen 0 und 2500 mm (Position der Messspulenanordnung im Stator);

Fig. 5    Polardarstellung entsprechend Fig. 4 für den Bereich zwischen 0 und 3000 mm (Position der Messspulenanordnung im Stator); und

Fig. 6    eine schematische Darstellung der für die Messung relevanten Vektoren im Polardiagramm.

## WEGE ZUR AUSFÜHRUNG DER ERFINDUNG

Das vorgeschlagene Verfahren zur Ermittlung von Fehlerstellen von Eisenblechpaketen basierend auf der Detektion des magnetischen Streufeldes, welches durch den in Kurzschlusskontakten fliessenden Strom erzeugt wird, bietet eine überlegene Alternative zu Verfahren mit hoher Induktion (so genannte "Hot spot" Verfahren). Das Verfahren wird bei einer niedrigen Magnetisierung des Stators durchgeführt, typischerweise bei einer Magnetisierung von 0,1 Tesla. Bei derartig niedrigen Magnetisierungen kann mit einem Standard 220/110 Volt Gerät zur Magnetisierung des Stators mit der Hilfswicklung gearbeitet werden (Allgemeines zum Verfahren vgl. CH 676526). Die Messung des Streufeldes erlaubt eine sehr genaue und detaillierte Ermittlung des Zustandes des lamellierten Eisenblechpaketes des Stators. Grundsätzlich geht es dabei um folgende Punkte:

- Identifikation von problematischen Bereichen

- Aussonderung von unkritischen Signalen ("Scheinsignalen")

- Quantifizierung der identifizierten Fehlerstellen und deren Klassifikation als gefährlich respektive ungefährlich

- Lokalisierung von allen identifizierten Fehlerstellen auch am Nutgrund oder an der Seitenwand der Nut

Diese Ziele werden erreicht, indem ein detailliertes Mapping des Streufeldes oberhalb der Statorzähne durchgeführt wird. Das Streufeld wird dabei mit einer Messspulenanordnung, welche auf einem Roboterträger montiert ist, und welche entlang des Spaltes zwischen Rotor und Stator geführt wird, ausgemessen. Sowohl die Amplitude als auch die Phase der in der Messspulenanordnung induzierten Spannung wird dabei aufgezeichnet.

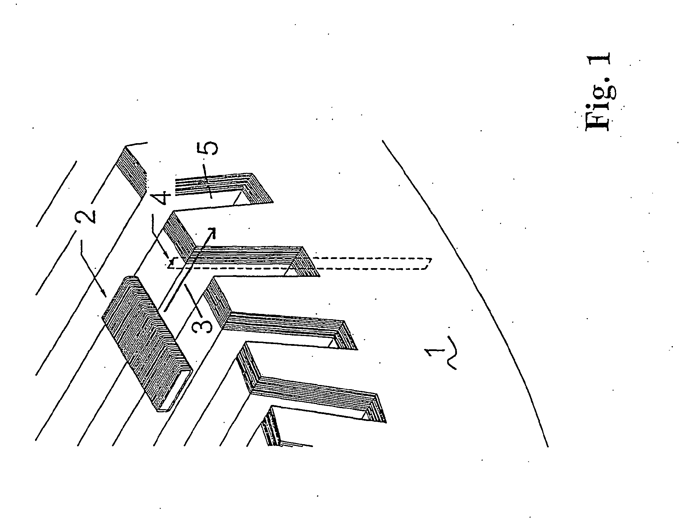

Fig. 1 zeigt, wie dabei vorgegangen wird. Mit einer Hilfswicklung (nicht dargestellt, vgl. dazu aber Fig. 1 der CH 676526) wird der Stator, d.h. das lamellierte Eisenblechpaket 1 zunächst als gesamtes leicht magnetisiert. Dabei wird üblicherweise mit einer Spannung von entweder 220 oder 110 Volt bei 50 bis 60 Hz gearbeitet. Danach wird die Messspulenanordnung 2 in axialer Bewegungsrichtung 3 über dem Blechpaket 1 des Stators verschoben und gleichzeitig die induzierte Spannung sowie die induzierte Phase aufgezeichnet. Tritt zwischen den einzelnen Schichten des lamellierten Eisenblechpakets 1 ein Fehlerstrom 4, d.h. ein Kurzschlussstrom auf, so induziert dieser in der Messspulenanordnung 2 eine Spannung mit einer bestimmten Phase. Dies ist bei eingebauten Leitern (in Fig. 1 nicht dargestellt) in den Statornuten 5 möglich. Die Genauigkeit der Lokalisierung von Kurzschlussstellen auch am Nutgrund respektive an den Seitenwänden der Statornuten 5 kann dabei dadurch erhöht werden, dass zwei Messspulenanordnungen 2 übereinander angeordnet werden, und damit der Gradient des Streufeldes auf den Statorzähnen im Detail ausgemessen wird. Je näher sich eine Fehlerstelle an den Messspulenanordnungen 2 befindet, um so ausgeprägter wird der Gradient ausfallen, was eine Lokalisierung der Fehlerstelle in radialer Richtung erlaubt (vgl. dazu das Verfahren, wie es in der CH 676526 beschrieben ist).

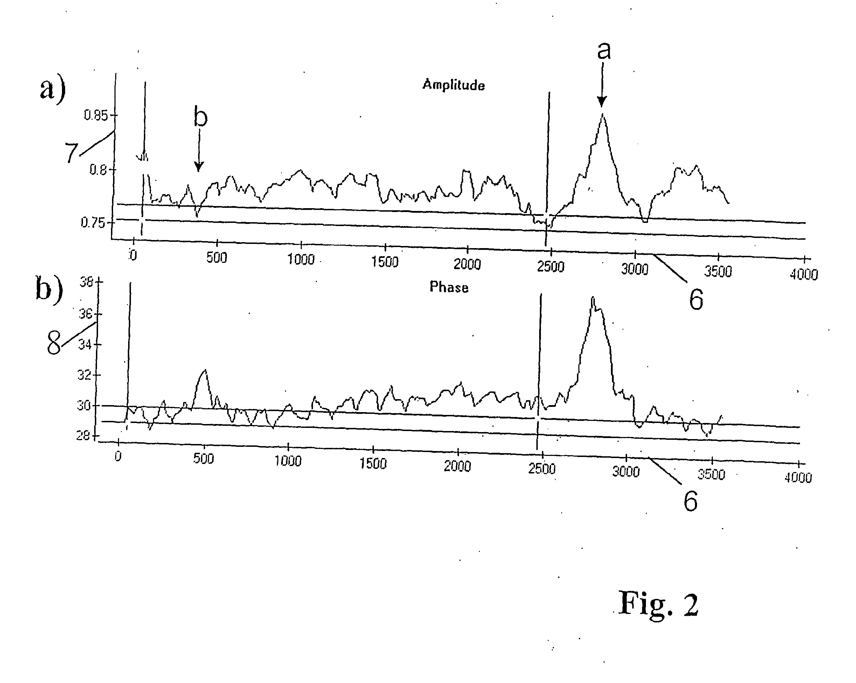

Eine Datenverarbeitungseinheit (nicht dargestellt) zeichnet sowohl Amplitude 7 als auch Phase 8 als Funktion der Position 6 der Messspulenanordnung 2 für jede Statornut 5 auf. Dabei wird die Phase 8 üblicherweise mit Hilfe eines vorgeschalteten Phasendetektors ermittelt. Der gemessene Phasenwinkel ist unabhängig von der Jochinduktion während der Messung. Fig. 2 zeigt eine derartige Auftragung von Amplitude 7 respektive Phase 8 als Funktion der axialen Position 6 der Messspulenanordnung 2 in Millimetern im Stator. Die gezeigten Daten wurden in einer 50 MW Maschine ermittelt. Bei Betrachtung der beiden Kurven a) und b) wird offensichtlich, dass die Unterscheidung von wirklichen Fehlerstellen a von vermuteten Fehlerstellen (unkritische Bereiche) b sehr schwierig ist.

Solche vermuteten Fehlerstellen b resultieren aus umfangsmässigen Asymmetrien der Konstruktion des Stators, wie sie z.B. bei Kühlschlitzen entstehen, oder aus lokalen mechanischen Belastungen des lamellierten Eisenblechpaketes 1. Es ist enorm wichtig, diese an sich unkritischen Bereiche von den wirklichen Fehlerstellen a zu unterscheiden, um unnötige Reparaturen und damit verbundene Kosten zu verhindern. Das vorliegende Verfahren ist nun eben genau in der Lage, unkritische Bereiche zu erkennen und von wirklichen Fehlerstellen, wie die Fehlerstelle a in Fig. 2, zu unterscheiden.

Die Spule der Messspulenanordnung 2 wird derart gestaltet, dass das Signal einer Fehlerstelle in einem weiten Bereich linear mit der axialen Länge zusammenhängt, über welche der Strom in der Fehlerstelle fliesst. Auf Grund der konstanten Spannung pro Einheitslänge im Stator kann das Signal als Funktion der in der Fehlerstelle auftretenden Leistung interpretiert werden:

$$Signal \propto I \times l$$

$$\propto (I \times l) \times \left(\frac{V}{l}\right) \qquad \text{da } \frac{V}{l} = const$$

$$\propto Leistung$$

Diese Leistung ist die totale Leistung, welche mit dem Strom (Kurzschlussstrom) in der Fehlerstelle verbunden ist. Die Leistung in der Kontaktstelle kann nicht grösser sein als dieser Wert. Die identifizierte Fehlerstelle kann deshalb in Bezug auf die maximal mögliche, in der Fehlerstelle am Kurzschluss dissipierten Leistung quantifiziert werden. Diese Leistung wird auf Nenninduktion umgerechnet. Als Grenzwert dient dabei üblicherweise ein Wert von 15W. Erst dadurch ist es möglich, einen wirklich direkten Zusammenhang zwischen dem Messwert und dem möglichen Schaden einer derartigen Fehlerstelle beim Betrieb der Anlage festzulegen.

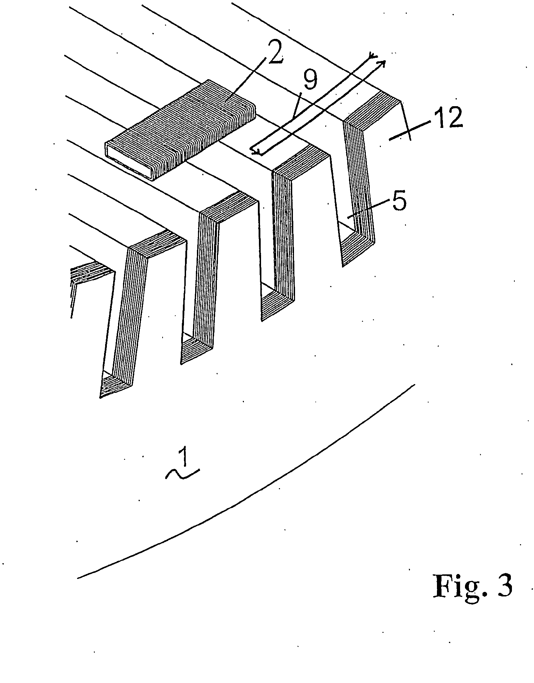

Die vollständig quantitative Interpretation der Rohdaten als Funktion der maximalen Kontaktleistung erfordert den Vergleich mit einer Referenzmessung. Zu diesem Zwecke wird, wie in Fig. 3 dargestellt, und wie zum Beispiel in der US 4996486 beschrieben, eine Eichstrom-Spule 9 über die Statorzähne 12 gelegt und mit einem bekannten Strom angesteuert. Der durch die Eichstrom-Spule 9 geschickte Strom entspricht dabei einem dem Blechschlussstrom entsprechenden Wert. Die Blechschlussströme von kurzgeschlossenen Blechen sind aus den bekannten Spannungswerten zwischen den Blechen und der Impedanz der kurz geschlossenen Bleche definiert. Das Signal der Messspulen wird dann mit und ohne diesen Strom registriert und mit dem des Blechschlussstromes verglichen. Mit anderen Worten wird eine Fehlerstelle simuliert, welche anschliessend in der Analyse berücksichtigt werden kann.

Wie bereits oben erwähnt ist die wesentliche Aufgabe, wirkliche Fehlerstellen zu erkennen. Dafür werden die induzierte Spannung und deren Phase aufgezeichnet und anschliessend Wirk- respektive Scheinanteil, d.h. Realteil 10 respektive Imaginärteil 11 berechnet.

Es stellt es sich dabei heraus, dass Signale von Fehlerstellen dadurch gekennzeichnet sind, dass der Realteil 10, d.h. der Wirkanteil, die Wirkleistung, wesentlich grösser ist als der induktive Imaginärteil 11, d.h. der Scheinanteil, respektive die Blindleistung. Mit anderen Worten stellt sich heraus, dass der Vektor in den fehlerfreien Bereichen im wesentlichen nur in Bezug auf den Imaginärteil schwankt, während Fehlerstellen grosse Ausschläge des Realteils 10 zeigen. Dies kann auf eindrückliche und ausserdem für Datenverarbeitungsprogramme gut benutzbarer Weise in Vektordarstellung z.B. mit Hilfe von Polardiagrammen mit Kriterien verarbeitet resp. visualisiert werden.

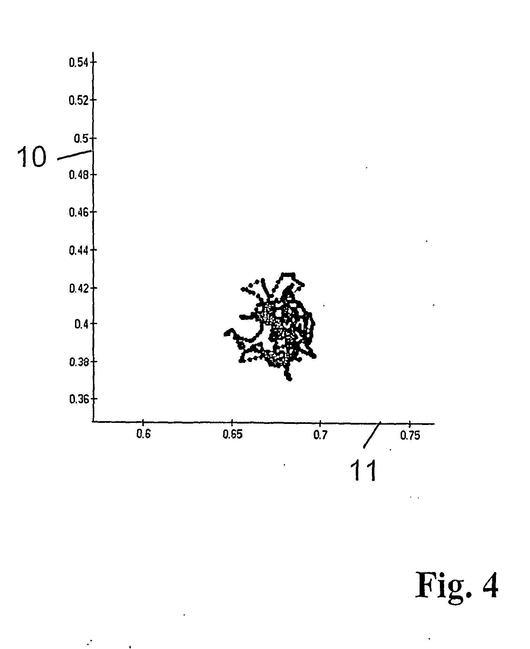

Entsprechend zeigt Fig. 4 die Daten gemäss Fig. 2 in einem Polardiagramm für den Bereich von 0 bis 2500 Millimeter. In diesem Bereich befindet sich die vermutete Fehlerstelle b, welche insbesondere auf der Ebene der Phase sichtbar ist. Das Polardiagramm zeigt jedoch klar an, dass es sich dabei nicht um eine Fehlerstelle handeln kann, denn der Vektor bewegt sich kaum in vertikaler Richtung, d.h. in Richtung der Achse des Realteils 10.

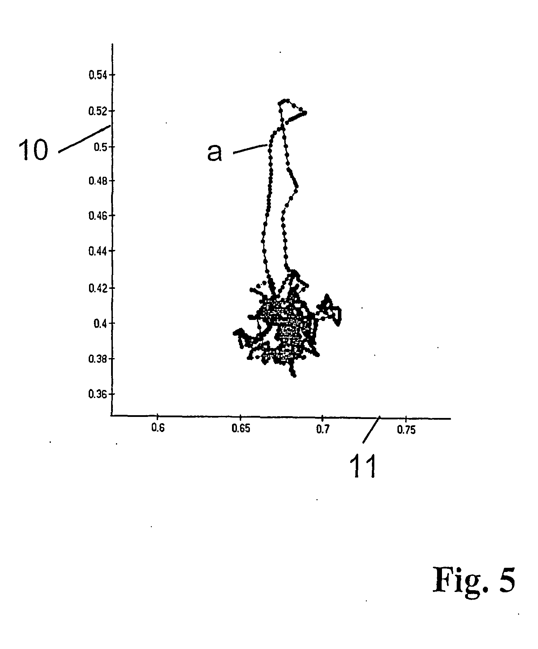

Fig. 5 zeigt ebenfalls die Daten gemäss Fig. 2 in einem Polardiagramm für den Bereich von 0 bis 3000 Millimeter, d.h. über den ganzen in Fig. 2 dargestellten Bereich. Hier wird nun klar ersichtlich, dass die Fehlerstelle a mit einem grossen Ausschlag in positiver vertikaler Richtung verbunden ist, d.h. dass für diesen Bereich der Realteil 10 einen wesentlichen Ausschlag zeigt. Üblicherweise lassen sich solche Fehlerstellen daran erkennen, dass der Realteil 10 des Signals im Polardiagramm eine wesentliche Erhöhung aufweist. Die Folge der Messpunkte in der Fehlerstelle ist charakterisiert durch einen eindeutigen vektoriellen Ausschlag mit ausgeprägt anderer Richtung als die Folge der Messpunkte an einer fehlerlosen Stelle.

In Bezug auf die Datenverarbeitung zur Identifikation der Fehlerstellen wird dabei so vorgegangen, dass zunächst gewissermassen ein charakteristischer typischer Hintergrundswert ", d.h. ein typischer Schwankungsbereich (welcher von den " gesunden "Bereichen bestimmt ist) der Vektoren in Bezug auf Real- und Imaginärteil ermittelt wird, anschliessend ein Schwellenwert in Bezug auf den Realteil festgelegt wird, und zuletzt alle Bereiche, in welchem der Vektor diesen Schwellenwert überschreitet, als kritisch markiert werden.

Der Schwellenwert ist grundsätzlich durch die weiter oben beschriebene Referenzmessung gegeben. Repariert wird nur, wenn der Vektor einer maximal möglichen Leistung von 15 Watt entspricht.

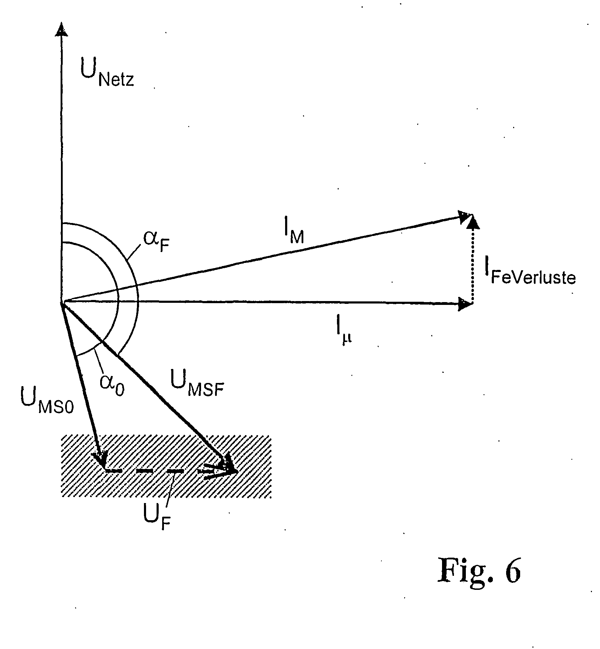

Figur 6 zeigt im Detail die für die vorliegende Messung relevanten Vektoren im Polardiagramm. Der Magnetisierungsstrom des Eisens $I_\mu$ wird um einen Verlustanteil $I_{FeVerluste}$ modifiziert, so dass ein tatsächlich benötigter Magnetisierungsstrom $I_M$ angelegt werden muss. Die angelegte Netzspannung $U_{Netz}$ ist auf der vertikalen Achse eingezeichnet. Gegenüber dieser Spannung wird die Phasenverschiebung bestimmt. Die Vektoren $U_{MS0}$ und $U_{MSF}$ bezeichnen nun die in der Messspule induzierten Spannungen. Dabei steht $U_{MS0}$ für die Spannung, welche ohne Vorliegen eines Fehlers induziert wird, und $U_{MSF}$ für die Spannung, welche bei Vorliegen eines Fehlers induziert wird. Die im Vektordiagramm eingezeichnete Größe $U_F$ steht nun für den im Text jeweils mit Realteil, oder mit "ausgeprägte Richtung" bezeichneten Teil. Der schraffierte Bereich entspricht dem Polardiagrammbereich, wie er für die Bestimmung von Fehlerstellen im Sinne dieser Erfindung verwendet wird. Im Polardiagramm werden also nur die Vektorspitzen der Vektoren $U_{MS0}$ und $U_{MSF}$ dargestellt. Der ebenfalls in der Figur angegebene Winkel $\alpha_0$ steht für den Phasenwinkel ohne Fehler und $\alpha_F$ für den entsprechenden Phasenwinkel bei Vorliegen einer Fehlerstelle.

Es zeigt sich mit anderen Worten, dass erst die kombinierte Analyse von Amplituden- und Phaseninformation des aufgezeichneten Signals, nach Kalibration mit Hilfe einer Eichstrom-Spule, eine zuverlässige Identifikation der Fehlerstellen erlaubt, und deren quantitative Erfassung ermöglicht. Das vorgeschlagene Verfahren erlaubt eine umfassende Beurteilung des lamellierten Eisenblechpaketes, und auf eine weitere Untersuchung mit Hilfe eines Hochinduktionsverfahrens kann deshalb üblicherweise verzichtet werden.

Ein weiterer wesentticher Vorteil des vorliegenden Verfahrens ist darin zu sehen, dass die Messung beliebig wiederholt werden kann und Phasenwerte im wesentlichen unabhängig von der Magnetisierung des Stators sind. Mit anderen Worten kann jede Messung als Messung eines "Fingerprint" des Stators betrachtet werden. Entsprechend ist es möglich, diesen " Fingerprint "immer wieder, d.h. über mehrere Jahre auszumessen und als Trendanalyse zu verwenden. Eine periodische Ausmessung des Stators kann so dazu verwendet werden, Tendenzen im Zustand des Stators zu erkennen, und Reparaturen jeweils nur wenn wirklich notwendig, durchzuführen.

**BEZUGSZEICHENLISTE**

| | |
|---|---|
| 1 | lamelliertes Eisenblechpaket |
| 2 | Messspulenanordnung |
| 3 | Bewegungsrichtung von 2 |
| 4 | Fehlerstrom (Kurzschlussstrom) |
| 5 | Statornut |
| 6 | Position von 2 |
| 7 | Amplitude |
| 8 | Phase |
| 9 | Eichstrom-Spule |
| 10 | Realteil des Vektordiagramms |
| 11 | Imaginärteil des Vektordiagramms |
| 12 | Statorzahn |
| a | Fehlerstelle |
| b | vermutete Fehlerstelle |
| $I_\mu$ | Magnetisierungsstrom des Eisens |
| $I_{FeVerluste}$ | Verluste im Eisen bei Magnetisierung für die Messung |
| $I_M$ | tatsächlich benötigter Magnetisierungsstrom |
| $U_{Netz}$ | Netzspannung |
| $U_{MS0}$ | In Messspule induzierte Spannung ohne Fehler |
| $U_{MSF}$ | In Messspule induzierte Spannung mit Fehler |
| $U_F$ | Realteil, ausgeprägte Richtung |
| $\alpha_0$ | Phasenwinkel ohne Fehler |
| $\alpha_F$ | Phasenwinkel mit Fehler |

**Patentansprüche**

**1.** Verfahren zur Kontrolle lamellierter Eisenblechpakete (1) von elektrischen Maschinen auf Blechschlüsse, bei welchem das Eisenblechpaket (1) mittels einer Hilfswicklung mit Wechselstrom magnetisiert wird und die Eisenoberfläche mittels wenigstens einer Messspulenanordnung (2) mit nachgeschaltetem Messgerät abgetastet wird, wobei als Messpunkte sowohl die Phase (8) als auch die Amplitude (7) des in der wenigstens einen Messspulenanordnung (2) induzierten elektrischen Signals als Funktion der Position der Messspulenanordnung (2) entlang der Statorachse kombiniert zur Lokalisierung von Blechschlüssen verwendet werden, **dadurch gekennzeichnet dass** Blechschlüsse durch einen im Vergleich zu den intakten Bereichen hohen Realteil (10) des induzierten elektrischen Signals lokalisiert werden, und wobei der hohe Realteil mit Hilfe einer Polardarstellung ermittelt wird, wobei der Realteil (10) die Vektorrichtung definiert, welcher durch eine Eichmessung ermittelt wird.

**2.** Verfahren nach Anspruch 1, **dadurch gekennzeichnet, dass** wenigstens eine weitere, von einer ersten Messspulenanordnung (2) elektrisch getrennte Messspulenanordnung radial distanziert, aber mechanisch mit der ersten Messspulenanordnung verbunden, verwendet wird, und sowohl die Phase (8) als auch die Amplitude (7) der wenigstens zwei in den wenigstens zwei Messspulenanordnungen (2) induzierten elektrischen Signale zur Lokalisierung von Blechschlüssen, insbesondere zu deren Lokalisierung in radialer Richtung, verwendet wird.

3. Verfahren nach einem der vorhergehenden Ansprüche, **dadurch gekennzeichnet, dass** die induzierten elektrischen Signale mit Signalen, die den Blechschlussströmen entsprechen, verglichen werden, wobei dazu als Referenz eine Eichstrom-Spule (9) mit entsprechender Breite an der Oberfläche des Eisenblechpakets (1) befestigt und mit entsprechendem Siechschlussstrom gespeist wird.

4. Verfahren nach Anspruch 3, **dadurch gekennzeichnet, dass** durch Vergleich mit der Referenz die Leistung in einem Blechschluss quantitativ bestimmt wird.

5. Verfahren nach einem der vorhergehenden Ansprüche, **dadurch gekennzeichnet, dass** die Aufmagnetisierung des Eisenblechpakets (1) insbesondere über die Rotorwelle aus einer stromstarken Speisequelle, die zwischen beiden Maschinenseiten insbesondere an der isolierten Welle angeschlossen ist, erfolgt, wobei insbesondere eine Magnetisierung des Eisenblechpakets (1) im Bereich von 0,03 bis 0,7 Tesla, insbesondere von 0,1 Tesla mit einer Spannung von 220/110 Volt bei 50/60 Hz erzeugt wird.

6. Verfahren nach einem der vorhergehenden Ansprüche, **dadurch gekennzeichnet, dass** die wenigstens eine Messspulenanordnung (2) in axialer Richtung auf dem Eisenblechpaket (1) verschoben wird, und dabei die induzierten Signale, insbesondere in Form eines Fingerprint, als Funktion der Position der Messspulenanordnung (2) ermittelt werden, wobei insbesondere Bereiche mit kritischen Blechschlüssen über den Realteil (10) ermittelt und von Bereichen mit unkritischen Blechschlüssen unterschieden werden, und wobei die kritischen Bereiche zur sofortigen Behebung markiert und die momentan noch unkritischen Bereiche für spätere Analysen dokumentiert werden.

7. Verfahren nach einem der Ansprüche 1-6, **dadurch gekennzeichnet, dass** Blechschlüsse durch einen eindeutigen vektoriellen Ausschlag der Folge der Messpunkte mit ausgeprägt anderer Richtung als die Folge der Messpunkte an einer fehlerlosen Stelle charakterisiert werden.

8. Verfahren nach Anspruch 7, **dadurch gekennzeichnet, dass** sich der eindeutige vektorielle Ausschlag der Folge der Messpunkte bei einem Blechschluss in Bezug auf den Realteil von Messpunkten an fehlerlosen Stellen unterscheidet.

9. Verfahren nach Anspruch 7 oder 8, **dadurch gekennzeichnet, dass** der vektorielle Ausschlag durch einen Vergleich mit einer Referenzmessung, bei welcher eine Eichstrom-Spule (9) über Statorzähne (12) gelegt wird und mit einem bekannten Strom angesteuert wird, ermittelt wird.

10. Verfahren nach einem der Ansprüche 7-9, **dadurch gekennzeichnet, dass** das Signal des vektoriellen Ausschlages proportional zur maximal möglichen, in der Fehlerstelle am Kurzschluss dissipierten Leistung ist.

11. Verfahren nach einem der Ansprüche 7-10, **dadurch gekennzeichnet, dass** die Länge des vektoriellen Ausschlages proportional zum Strom in der Fehlerstelle ist.

12. Vorrichtung zur Durchführung eines Verfahrens nach einem der Ansprüche 1 bis 11, umfassend erste Mittel zur Bestimmung der Position der Messspulenanordnung (2) auf dem Eisenblechpaket (1), und umfassend zweite Mittel zur Erfassung von Amplitude (7) und Phase (8), insbesondere mit Hilfe eines Phasendetektors, der in der Messspulenanordnung (2) induzierten elektrischen Spannung, und umfassend weiterhin eine Datenverarbeitungseinheit zur Analyse der gemessenen Daten, welche insbesondere dazu in der Lage ist, kritische Blechschlüsse zu lokalisieren und durch Vergleich mit einer Referenz die darin auftretende Leistung zu ermitteln, **dadurch gekennzeichnet dass** die Datenverarbeitungseinheit so eingerichtet ist, dass Blechschlüsse durch einen im Vergleich zu den intakten Bereichen hohen Realteil (10) des induzierten elektrischen Signals lokalisiert werden, und dass der hohe Realteil mit Hilfe einer Polardarstellung ermittelt wird, wobei der Realteil (10) die durch eine Eichmessung ermittelte Vektorrichtung definiert.

13. Vorrichtung nach Anspruch 12, **dadurch gekennzeichnet, dass** zur Durchführung der Analyse in der Datenverarbeitungseinheit ein Computerprogramm vorgesehen ist, welches die erfassten Daten, das heisst Phase (8) und Amplitude (7) des in der Messspulenanordnung (2) induzierten elektrischen Stromes, bevorzugt nach deren Abgleich mit einer Referenz, in eine Vektordarstellung im Sinne eines Polardiagramms bringt und Fehlerstellen (a) automatisch erkennt.

**14.** Vorrichtung nach Anspruch 13, **dadurch gekennzeichnet, dass** Fehlerstellen (a) dadurch bestimmt sind ermittelt werden, dass der Realteil (10) des Signals einen vorgegebenen Grenzwert überschreitet.

**Claims**

**1.** Method for inspecting laminated iron cores (1) of electrical machines for interlamination shorts, in which the laminated iron core (1) is magnetized by means of an auxiliary winding using alternating current, and the iron surface is scanned by means of at least one measurement coil arrangement (2) with a downstream measurement device, both the phase (8) and the amplitude (7) of the electrical signal which is induced in the at least one measurement coil arrangement (2) being used in combined form to localize interlamination shorts as a function of the position of the measurement coil arrangement (2) along the stator axis, **characterized in that** interlamination shorts are localized by means of a real part (10) of the induced electrical signal, which is high in comparison to the intact regions, and the high real part being determined by means of a polar representation, with the real part (10) defining the vector direction and being determined by the calibration measurement.

**2.** Method according to Claim 1, **characterized in that** at least one further measurement coil arrangement, which is electrically isolated from a first measurement coil arrangement (2) is used, and is radially at a distance but is mechanically connected to the first measurement coil arrangement, and both the phase (8) and the amplitude (7) of the at least two electrical signals, which are induced in the at least two measurement coil arrangements (2), are used to localize interlamination shorts, in particular to localize them in the radial direction.

**3.** Method according to one of the preceding claims, **characterized in that** the induced electrical signals are compared with signals which correspond to the interlamination short currents, with a calibration current coil (9) with an appropriate width being mounted on the surface of the laminated iron core (1) as a reference for this purpose, and being fed with an appropriate interlamination short current.

**4.** Method according to Claim 3, **characterized in that** the volt-amperes in an interlamination short are determined quantitatively by comparison with the reference.

**5.** Method according to one of the preceding claims, **characterized in that** the laminated iron core (1) is magnetized in particular via the rotor shaft from a high-power supply source which is connected between the two machine sides, in particular on the insulated shaft, in particular with the laminated iron core (1) being magnetized in the range from 0.03 to 0.7 Tesla, in particular approximately 0.1 Tesla, with a voltage of 220/110 volts at 50/60 Hz.

**6.** Method according to one of the preceding claims, **characterized in that** the at least one measurement coil arrangement (2) is shifted on the laminated iron core (1) in the axial direction, and, in the process, the induced signals are determined, in particular in the form of a fingerprint, as a function of the position of the measurement coil arrangement (2), with regions with critical interlamination shorts being determined, in particular, via the real part (10) and being distinguished from regions with noncritical interlamination shorts, and with the critical regions being marked for immediate rectification, and the regions which are still noncritical at that time being documented for later analysis.

**7.** Method according to one of Claims 1-6, **characterized in that** interlamination shorts are **characterized by** a clear vectorial deflection of the sequence of measurement points in a pronouncedly different direction than the sequence of measurement points at a fault-free point.

**8.** Method according to Claim 7, **characterized in that** a clear vectorial deflection of the sequence of measurement points differs in an interlamination short in relation to the real part of measurement points at fault-free points.

**9.** Method according to Claim 7 or 8, **characterized in that** the vectorial deflection is determined by comparison with a reference measurement, in which a calibration current coil (9) is placed over stator teeth (12) and is driven with a known current.

**10.** Method according to one of Claims 7-9, **characterized in that** the signal of the vectorial deflection is proportional to the maximum possible power dissipated in the fault point at the short circuit.

11. Method according to one of Claims 7-10, **characterized in that** the length of the vectorial deflection is proportional to the current in the fault point.

12. Apparatus for carrying out a method as claimed in one of Claims 1 to 11, comprising first means for determining the position of the measurement coil arrangement (2) on the laminated iron core (1), and comprising second means for detecting the amplitude (7) and the phase (8), in particular by means of a phase detector, of the electrical voltage which is induced in the measurement coil arrangement (2), and also comprising a data processing unit for analysis of the measured data, which, in particular, is able to localize critical interlamination shorts and to determine the volt-amperes flowing in them, by comparison with a reference, **characterized in that** the data processing unit is designed such that interlamination shorts are localized by means of a real part (10) of the induced electrical signal, which is high in comparison to the intact regions, and the high real part is determined by means of a polar representation, with the real part (10) defining the vector direction determined by a calibration measurement.

13. Apparatus according to Claim 12, **characterized in that**, for carrying out the analysis in the data processing unit a computer program is provided which changes the acquired data, that is to say the phase (8) and amplitude (7) of the electrical current which is induced in the measurement coil arrangement (2), to a vector representation in the form of a polar diagram, preferably after having been adjusted using a reference, and identifies fault points (a) automatically.

14. Apparatus according to Claim 13, **characterized in that** fault points (a) are determined by the real part (10) of the signal exceeding a predetermined limit value.

## Revendications

1. Procédé de contrôle d'empilements de tôles de fer lamellaires (1) de machines électriques à la recherche de courts-circuits entre tôles, dans lequel l'empilement de tôles de fer (1) est magnétisé au moyen d'un bobinage auxiliaire à courant alternatif et la surface de fer est explorée au moyen d'au moins un dispositif de bobine détectrice (2) avec un appareil de mesure monté en aval, dans lequel, en guise de points de mesure, aussi bien la phase (8) que l'amplitude (7) du signal électrique induit dans l'au moins un dispositif de bobine détectrice (2) en fonction de la position du dispositif de bobine détectrice (2) le long de l'axe du stator sont utilisées en combinaison pour la localisation des courts-circuits entre tôles, **caractérisé en ce que** les courts-circuits entre tôles sont localisés par une composante réelle (10) du signal électrique induit relativement élevée par rapport aux zones intactes, et dans lequel la composante réelle élevée est déterminée à l'aide d'une représentation polaire, la composante réelle (10) définissant la direction de vecteur qui est déterminée par une mesure d'étalonnage.

2. Procédé selon la revendication 1, **caractérisé en ce qu'**au moins un autre dispositif de bobine détectrice isolé électriquement du premier dispositif de bobine détectrice (2), éloigné radialement mais relié mécaniquement avec le premier dispositif de bobine détectrice et utilisé, et qu'aussi bien la phase (8) que l'amplitude (7) des au moins deux signaux électriques induits dans les au moins deux dispositifs de bobine détectrice (2) sont utilisées pour la localisation des courts-circuits entre tôles, en particulier pour leur localisation dans la direction radiale.

3. Procédé selon l'une quelconque des revendications précédentes, **caractérisé en ce que** les signaux électriques induits sont comparés avec des signaux qui correspondent aux courants de court-circuit entre tôles, une bobine de courant étalon (9) d'une largeur appropriée étant fixée à la surface de l'empilement de tôles de fer (1) en guise de référence et alimentée avec un courant de court-circuit entre tôles approprié.

4. Procédé selon la revendication 3, **caractérisé en ce que** la puissance dans le court-circuit entre tôles est déterminée quantitativement par comparaison avec la référence.

5. Procédé selon l'une quelconque des revendications précédentes, **caractérisé en ce que** la magnétisation de l'empilement de tôles de fer (1) est produite en particulier via l'arbre de rotor, à partir d'une source d'alimentation à courant fort qui est connectée entre les deux côtés de la machine, en particulier sur l'arbre isolé, une magnétisation de l'empilement de tôles de fer (1) étant générée sur la plage de 0,03 à 0,7 teslas, en particulier de 0,1 tesla avec une tension de 220/110 volts à 50/60 Hz.

6. Procédé selon l'une quelconque des revendications précédentes, **caractérisé en ce que** l'au moins un dispositif de bobine détectrice (2) est déplacé dans la direction axiale sur l'empilement de tôles de fer (1), et que les signaux induits, en particulier sous forme d'empreinte digitale, sont alors déterminés en fonction de la position du dispositif de bobine détectrice (2), les zones avec des courts-circuits entre tôles critiques étant en particulier déterminées par la composante réelle (10) et différenciées des zones avec des courts-circuits entre tôles non critiques, et dans lequel les zones critiques sont repérées pour un dépannage immédiat et les zones non critiques pour le moment sont consignées pour des analyses ultérieures.

7. Procédé selon l'une quelconque des revendications 1 à 6, **caractérisé en ce que** les courts-circuits entre tôles sont **caractérisés par** une variation vectorielle claire de la série de points de mesure dans une direction nettement différente de la série de points de mesure sur un point sans défaillance.

8. Procédé selon la revendication 7, **caractérisé en ce que**, en cas de court-circuit entre tôles, la variation vectorielle claire de la série de points de mesure se distingue par rapport à la composante réelle des points de mesure sur les points sans défaillance.

9. Procédé selon la revendication 7 ou 8, **caractérisé en ce que** la variation vectorielle est déterminée par une comparaison avec une mesure de référence pour laquelle une bobine à courant étalon (9) est montée au-dessus des dents de stator (12) et contrôlée avec un courant connu.

10. Procédé selon l'une quelconque des revendications 7 à 9, **caractérisé en ce que** le signal de la variation vectorielle est proportionnel à la puissance maximum possible dissipée au niveau du court-circuit au point de défaillance.

11. Procédé selon l'une quelconque des revendications 7 à 10, **caractérisé en ce que** la longueur de la variation vectorielle est proportionnelle au courant au point de défaillance.

12. Dispositif pour mettre en oeuvre un procédé selon une des revendications 1 à 11, comprenant des premiers moyens pour déterminer la position du dispositif de bobine détectrice (2) sur l'empilement de tôles de fer (1), et comprenant des deuxièmes moyens pour enregistrer l'amplitude (7) et la phase (8), en particulier à l'aide d'un détecteur de phase, de la tension électrique induite dans le dispositif de bobine détectrice (2), et comprenant en outre une unité informatique pour analyser les données mesurées, qui est en particulier capable de localiser les courts-circuits entre tôles critiques et de déterminer avec une référence la puissance s'y trouvant, **caractérisé en ce que** l'unité informatique est équipée de telle sorte que les courts-circuits entre tôles sont localisés par une composante réelle (10) du signal électrique induit relativement élevée par rapport aux zones intactes et que la composante réelle élevée est déterminée à l'aide d'une représentation polaire, la composante réelle (10) définissant la direction de vecteur déterminée par une mesure d'étalonnage.

13. Dispositif selon la revendication 12, **caractérisé en ce que**, pour réaliser l'analyse dans l'unité informatique, il est prévu un programme d'ordinateur qui agence les données enregistrées, c'est-à-dire la phase (8) et l'amplitude (7) du courant électrique induit dans le dispositif de bobine détectrice (2), de préférence après leur étalonnage avec une référence, dans une représentation vectorielle au sens d'un diagramme polaire et identifie automatiquement les points de défaillance (a).

14. Dispositif selon la revendication 13, **caractérisé en ce que** les points de défaillance (a) sont déterminés par le fait que la composante réelle (10) du signal dépasse une valeur limite prédéfinie.

Fig. 1

EP 1 430 297 B1

Fig. 2

Fig. 3

13

Fig. 4

Fig. 5

Fig. 6